# EUROPEAN PATENT APPLICATION

(11) **EP 1 940 214 A1**
(43) Date of publication of application: **02.07.2008**
(21) Application number: 06027050.1
(22) Date of filing: 29.12.2006
(51) Int. Cl.: H05K 9/00, B29C 59/04

(54) **Flexible foil and method for manufacturing the same**

(71) Applicant: Wang, Chao-Jen, Tainan Hsien (TW)
(72) Inventor: Wang, Chao-Jen, Tainan Hsien (TW)
(74) Representative: Horak, Michael

(57) **Abstract**

Disclosed is a flexible foil (4) including a thin and flexible foil that isolates electromagnetic waves. The foil has a smooth surface (41) and an opposite surface on which a plurality of three-dimensional raised projections (42) is formed and consecutively lined up. A slicing-facilitated, flexible thinned layer (43) is formed between adjacent ones of the projections. The foil can be deflected to enclose an electronic device that generates electromagnetic waves with the projections facing the electronic device so that the electromagnetic waves are confined inside the enclosure formed by the foil arid dispersed and dissipated by reflection and diffraction in multiple angles caused by the projections so as to prevent leakage of electromagnetic waves and to protect electronic components close to the electromagnetic wave generating device from interference by the electromagnetic waves.

## Description

### BACKGROUND OF THE INVENTION

### (a) Technical Field of the Invention

The present invention relates to a flexible foil, which can be used to enclose an electronic device that generates electromagnetic waves so as to effectively prevent leakage of electromagnetic waves. A method for manufacturing the foil is also provided.

### (b) Description of the Prior Art

High-precision electronic components, such as semiconductor chips, for example a central processing unit (CPU), and a liquid crystal display (LCD), are often operated with low voltage and/or low current. These electronic components are often used in computers and control and operation systems of machines. However, these high-precision electronic devices that are operated with low voltage and low current are liable to electromagnetic interference by minor electromagnetic waves. Thus, it is necessary to isolate these electronic components from any electronic device that generates electromagnetic waves in order to eliminate interference with the operation of these high-precision electronic components by the electromagnetic waves.

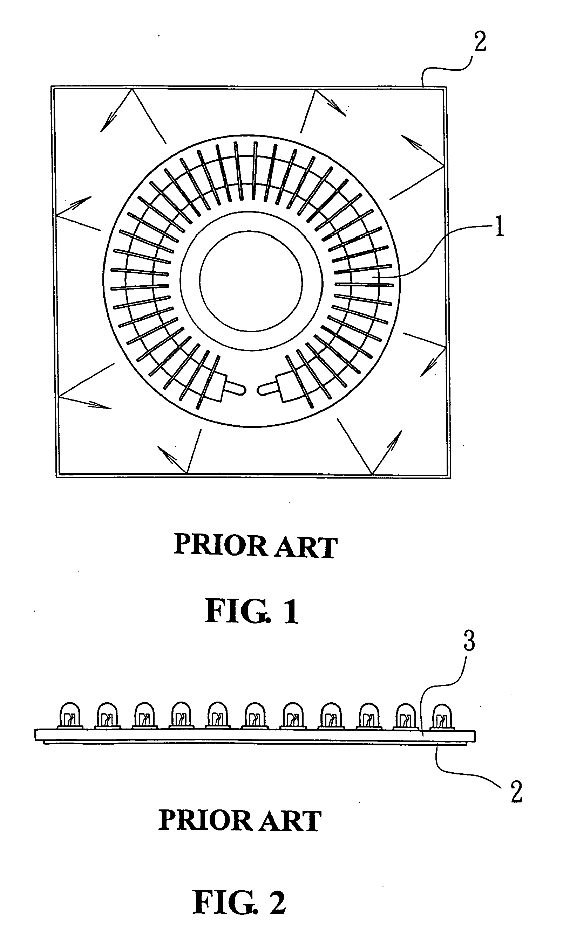

Figure 1 of the attached drawings illustrates a conventional structure for isolating electromagnetic waves generated by an electronic device. In the example, the electronic device that generates electromagnetic waves comprises a rectifier 1. A flat reflective foil 2, preferably made of metal or comprising metallic material, is arranged to enclose the rectifier 1. Due to reflection of electromagnetic wave by the metal foil 2, electromagnetic waves generated by the rectifier 1 is confined within the enclosure formed by the foil 2 and is prevented from leakage out of the enclosure. However, the flat configuration of the foil 2 is not very effective in efficiently dispersing and dissipating the electromagnetic waves. Further, the reflective foil 2 is commonly made of metals, including gold, silver, and copper, which facilitates conduction and dissipation of heat so as to help dissipating heat generated by the rectifier 1.

Referring to Figure 2, another application of the conventional foil 2 is shown. The foil 2 is attached to an object 3 from which heat generated thereby is to be dissipated. Examples of the object include a semiconductor chip, such as a central processing unit (CPU), a light-emitting diode or other lighting modules. The foil 2 can absorb heat generated by the object 3 and dissipates the heat to the surroundings through an opposite surface so as to regulate the temperature of the object 3. However, since the opposite surface of the foil 2 through which heat is dissipated is flat, the effectiveness of heat dissipation is limited.

Thus, it is desired to provide a foil that effectively dissipates electromagnetic wave and thermal energy so as to overcome the above drawbacks of the conventional foils.

### SUMMARY OF THE INVENTION

The primary purpose of the present invention is to The present invention relates to a flexible foil, which forms a plurality of three-dimensional raised projections and a slicing-facilitated flexible thinned layer formed between adjacent ones of the projections. The flexibility provided by the thinned layer allows the flexible foil to be deflected and enclosing an electronic device that generates electromagnetic waves with the projections facing the electronic device. The projections serve to reflect and diffract the electromagnetic waves in multiple angles so as to confine the electromagnetic waves inside the enclosure formed by the foil. The present invention also provides a method for manufacturing the flexible foil, comprising using rolling elements that are in continuous rotation to roll the foil so as to form the projections on one surface of the foil and then cutting the foil having the projections to desired sizes.

An objective of the present invention is to provide a flexible foil that is deformable to enclose an electronic device that generates electromagnetic waves. The flexible foil forms projections on one surface thereof, which faces the electronic device when the foil encloses the electronic device, so that the projections serve to reflect and diffract the electromagnetic waves in multiple angles to dissipate and confine the electromagnetic waves inside the enclosure formed by the foil. Therefore, interference with high-precision electronic components by the electromagnetic waves from the electronic device is effectively prevented.

Another objective of the present invention is to provide a flexible foil that features easy slicing and deflectability so as to allow the foil to be cut and deflect as desired.

A further objective of the present invention is to provide a method that employs rollers to continuously roll a flexible foil and thus forming projections on one surface of the foil. The continuous rolling of the foil allows for mass and efficient production of the flexible foil and thus reducing the costs of the foil to enhance market competitivity.

The foregoing object and summary provide only a brief introduction to the present invention. To fully appreciate these and other objects of the present invention as well as the invention itself, all of which will become apparent to those skilled in the art, the following detailed description of the invention and the claims should be read in conjunction with the accompanying drawings. Throughout the specification and drawings identical reference numerals refer to identical or similar parts.

Many other advantages and features of the present invention will become manifest to those versed in the art upon making reference to the detailed description and the accompanying sheets of drawings in which a preferred structural embodiment incorporating the principles of the present invention is shown by way of illustrative example.

### BRIEF DESCRIPTION OF THE DRAWINGS

The present invention will be apparent to those skilled in the art by reading the following description of preferred embodiments thereof, with reference to the attached drawings, wherein:
Figure 1 is a schematic view showing an application of a conventional reflective foil;
Figure 2 is a schematic view showing another application of a conventional reflective foil;
Figure 3 is a perspective view of a flexible foil constructed in accordance with the present invention, wherein a portion of the foil is shown in enlarged scale to illustrate structural details thereof;
Figure 4 schematically shows a manufacturing process of the flexible foil of the present invention;
Figure 5 is a flow chart of the manufacturing process of the flexible foil of the present invention;
Figure 6 schematically shows an application of the flexible foil of the present invention;
Figure 7 shows a schematic side view illustrating an application of the flexible foil of the present invention;
Figure 8 schematically shows a computer system in which the flexible foil of the present invention is employed for electromagnetic interference protection;
Figure 9 schematically shows a machine comprising a controller which the flexible foil of the present invention is employed for electromagnetic interference protection;
Figure 10 is a perspective view illustrating cutting of the flexible foil of the present invention;
Figure 11 is a perspective view illustrating cutting the flexible foil of the present invention with a pair of scissors;
Figure 12 is a perspective view illustrating cutting the flexible foil of the present invention with a knife blade;
Figure 13 is a side elevational view illustrating an application of the flexible foil of the present invention in an object having a flat surface from which heat is to be removed;
Figure 14 is a side elevational view illustrating an application of the flexible foil of the present invention in an object having a curved surface from which heat is to be removed;
Figure 15 is an end view showing the flexible foils of the present invention are stored in a deflected and circled manner;
Figure 16 is an end view showing the flexible foil of the present invention is stored in a roll;
Figure 17 is a perspective view showing a modification of the flexible foil of the present invention in which an adhesive layer is coated on a smooth surface of the foil and a release film is attached to the adhesive layer,
Figure 18 is an enlarged view of a portion of the flexible foil showing conic projections formed on the flexible foil;
Figure 19 is an enlarged view of a portion of the flexible foil showing pyramid projections formed on the flexible foil; and
Figure 20 is an enlarged view of a portion of the flexible foil showing hemispheric or dome-shaped projections formed on the flexible foil.

### DETAILED DESCRIPTION OF THE PREFERRED EMBODIMENTS

The following descriptions are of exemplary embodiments only, and are not intended to limit the scope, applicability or configuration of the invention in any way. Rather, the following description provides a convenient illustration for implementing exemplary embodiments of the invention. Various changes to the described embodiments may be made in the function and arrangement of the elements described without departing from the scope of the invention as set forth in the appended claims.

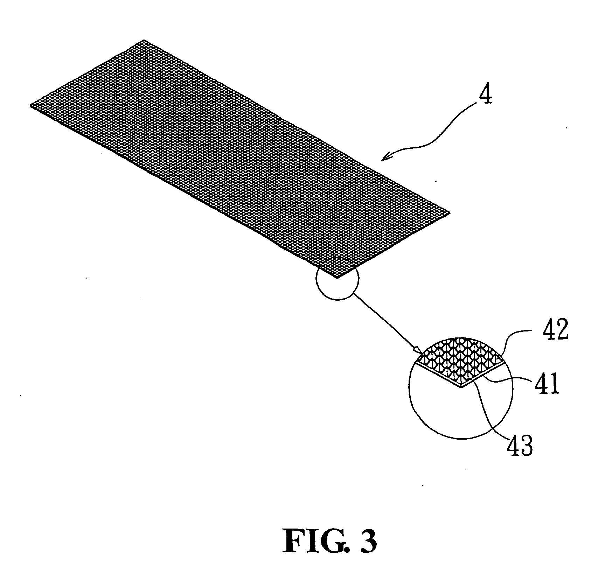

With reference to the drawings and in particular to Figure 3, a flexible foil constructed in accordance with the present invention, generally designated with reference numeral 4, comprises a sheet of material having a smooth surface 41 and an opposite surface on which a plurality of raised projections 42 is formed and arranged in a matrix by consecutively lining up in columns and rows. The projections 42 are of a predetermined height, which in the embodiment illustrated is between 0.05-1.5mm. A slicing-facilitated flexible thinned layer 43 is formed in a recessed portion (not labeled) between adjacent projections 42. The thickness from the smooth surface 41 to the thinned layer 43 is between 0.02-0.4mm.

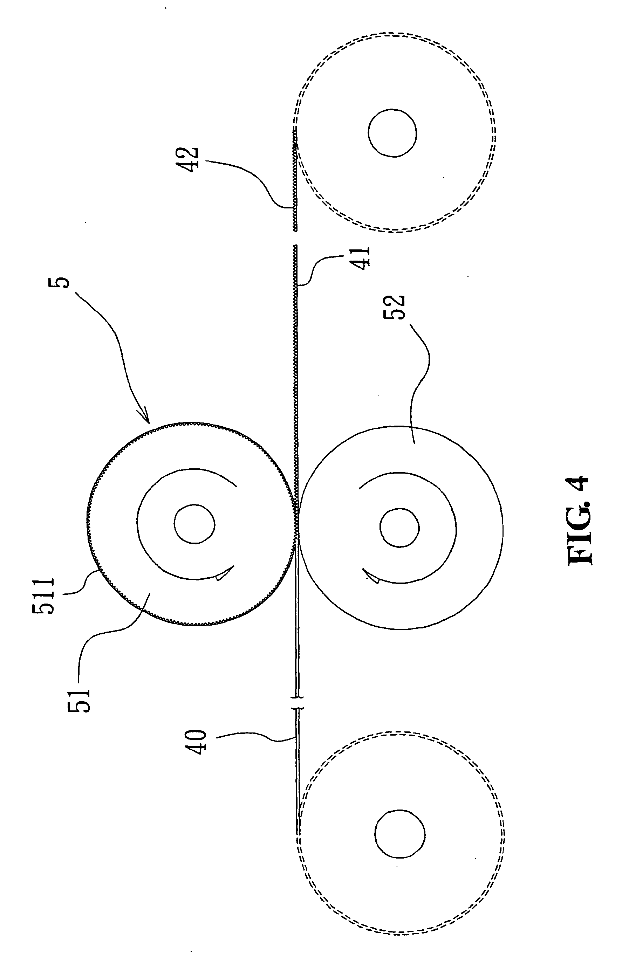

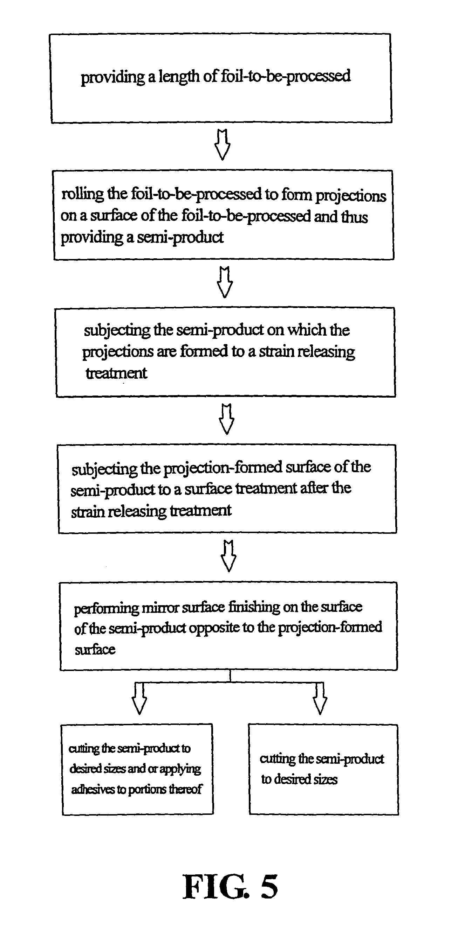

Also referring to Figures 4 and 5, a process for manufacturing the flexible foil 4 in accordance with the present invention will be described. The process comprises the following steps: Initially and as the first step, a length of foil-to-be-processed, generally designated with reference numeral 40, is provided in the form of a roll of raw material. The second step is to provide rolling elements 5 for continuously forging the foil-to-be-processed 40. The rolling elements 5 include a first roller 51 and a second roller 52. The first roller 51 has a circumferential surface on which rolling teeth 511 are formed. The teeth 511 can be of a polygonal conic shape. The first and second rollers 51, 52 are positioned opposite to and in tight engagement with each other. Thus, when the foil-to-be-processed 40 is fed between the rollers 51, 52, a substantial pressure is applied to the foil-to-be processed 40 by the rollers 51, 52, which causes the teeth 511 of the first roller 51 to at least partially pierce into the surface of the foil-to-be-processed 40 facing and engaging the first roller 51. The engagement between the rollers 51, 52 and the foil-to-be-processed 40 feeds the foil-to-be-processed 40 forward when the rollers 51, 52 rotate. Further, the teeth 511 of the first roller 51 piercing into the foil-to-be-processed 40 effectively form the projections 42 on the foil-to-be-processed 40 thereby providing a semi-product foil.

Next, the semi-product foil is processed to release strain induced in the semi-product foil. The semi-product foil that has the projections 42 formed thereon is then subject to an optional surface treatment on the projection-formed surface thereof Examples of the surface treatment include plating, quenching, and tempering, or a process of forming micro-structure on the surface. A further surface treatment, such as surface finishing or polishing, may be selectively performed on a smooth surface of the semi-product foil that is opposite to the projection-formed surface.

Thereafter, slicing or cutting is carried out on the surface-treated and projection-formed semi-product foil 40 to provide flexible foils 4 of desired sizes; or alternatively, adhesive application is performed on the surface-treated and projection-formed semi-product foil 40, in combination with slicing or cutting of the foil 40.

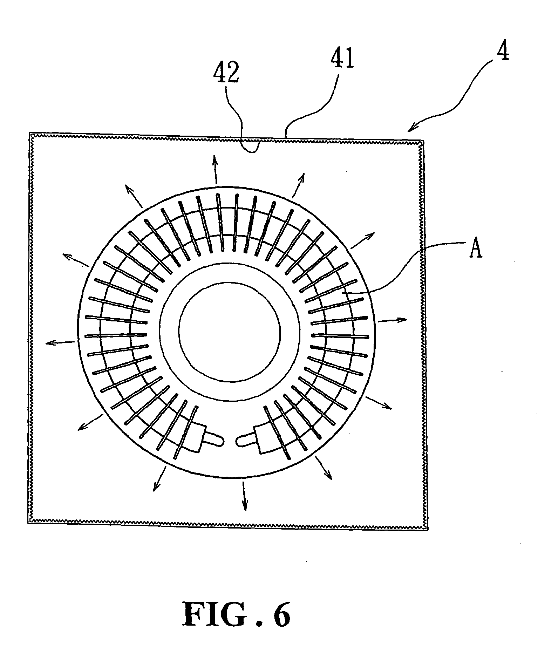

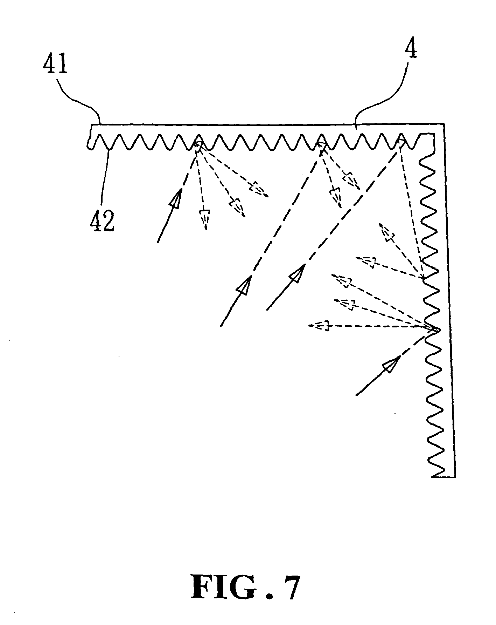

Figures 6-9 show different applications of the flexible foil 4 of the present invention. In the example shown in Figure 6, the flexible foil 4 encloses an electronic device A that generates electromagnetic waves. The electronic device A can be any known device, such as a conventional rectifier illustrated in Figure 1. The flexible foil 4 is arranged in such a way that the projections 42 of the foil 4 face the electronic device A whereby the projections 42 effect reflection and diffraction of electromagnetic wave in multiple angles inside the enclosure formed by the flexible foil 4, and thus effectively preventing the electromagnetic wave from leaking outside the enclosure. Figure 7 illustrates in a more detailed manner how the projections 42 reflect and diffract the electromagnetic wave inside the enclosure formed by the foil 4. The electromagnetic wave is confined inside the enclosure formed by the foil 4 and is then dispersed and dissipated.

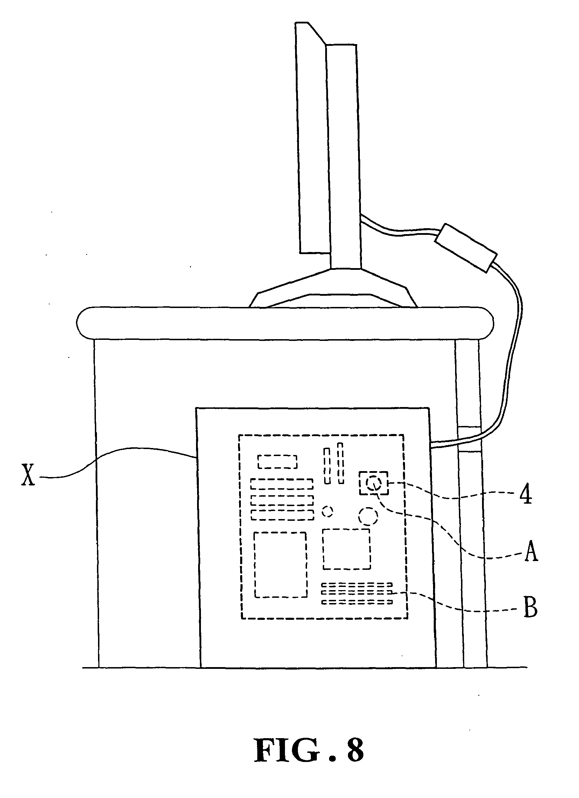

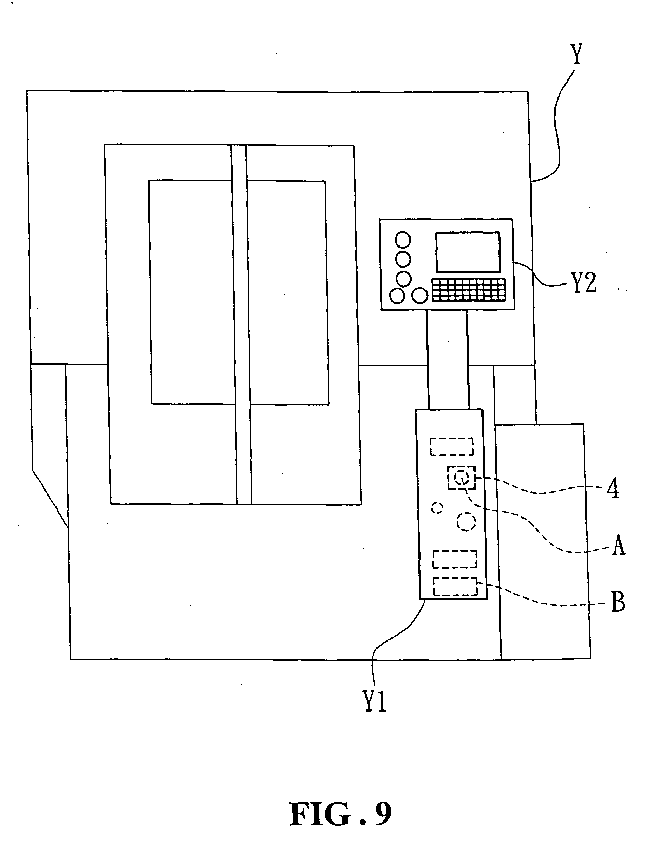

Figure 8 shows an application of the flexible foil 4 in a computer system X in which an electronic device A that generates electromagnetic wave is arranged. The flexible foil 4 forms an enclosure surrounding the electronic device A so as to protect a high-precision peripheral electronic component B that is also arranged inside the computer system X from being interfered with by the electromagnetic wave from the electronic device A. Figure 9 shows another application of the flexible foil 4 in a controller Y1 and a man-machine interface Y2 of a machine Y to prevent electromagnetic wave generated by an electronic device A that is incorporated in the controller Y1 from interfering with the operation of a high-precision peripheral electronic component B that is also arranged inside the controller Y1.

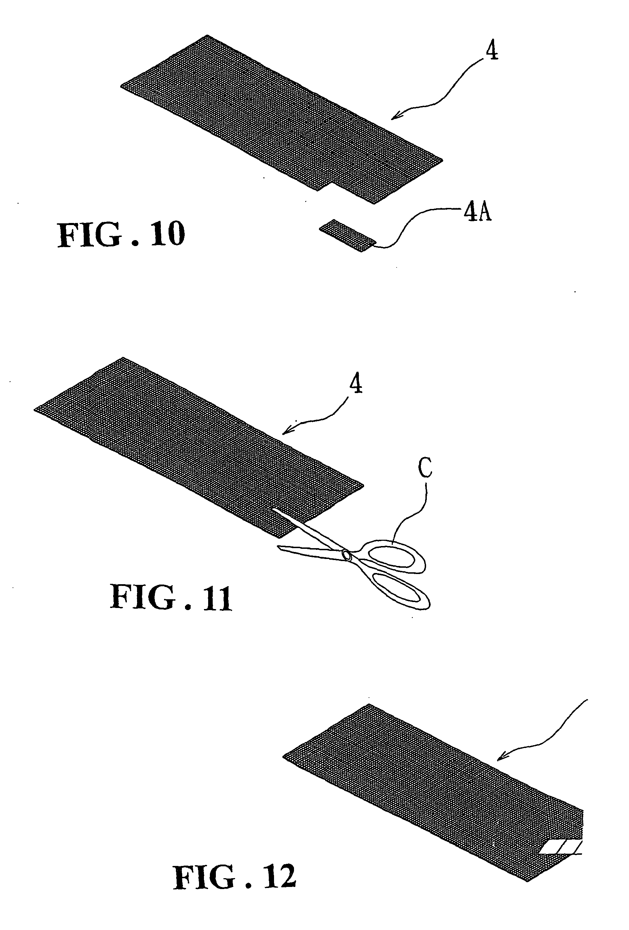

Figures 10, 11, and 12 shows cutting the flexible foil 4 to a desired size, as indicated in 4A. The cutting can be done with a pair of scissors C (Figure 11) or a knife blade D (Figure 12).

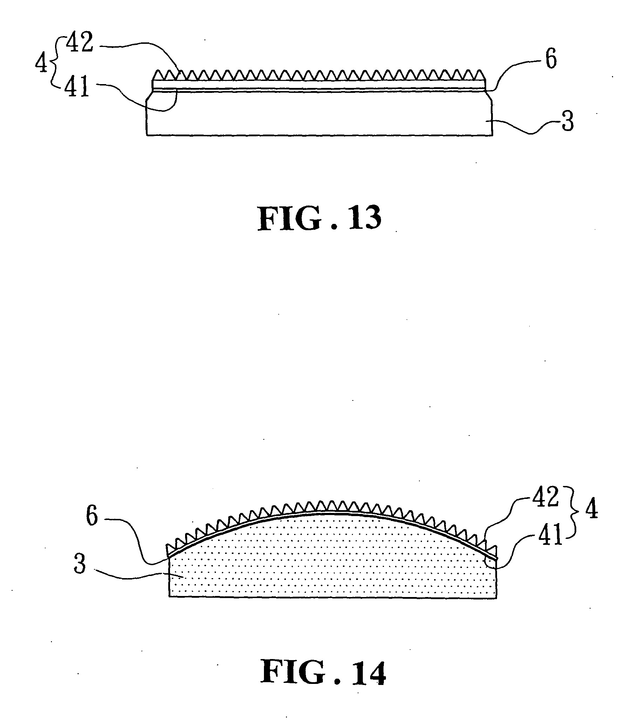

Figures 13 and 14 show examples of practical use of the flexible foil 4. In Figure 13, the flexible foil 4 is attached to an object 3, such as an object from which heat is to be dissipated, and this is done by applying a layer of adhesive 6 on the smooth surface 41 of that foil 4 that is opposite to the surface that forms the projections 42. In the example of Figure 13, the surface of the object 13 to which the foil 4 is attached is a flat surface. However, the surface to which the foil 4 is attached can be a curved surface or a curvature variable surface, as shown in Figure 14, wherein the flexible foil 4, due the flexibility thereof, is deflected and comply with the curved surface of the object 3. Similarly, a layer of adhesive 6 is applied to the smooth surface 41 of the flexible foil 4 to attach the foil 4 to the object 3 with the projections 42 facing outward and away from the object 3. Heat generated by the object 3 can be absorbed by the smooth surface 41 of the foil 4 that engages the object 3 and is further transferred to the projections 42 on the opposite surface of the foil 4 so as to allow the heat to be dissipated to the surroundings through the projections 42.

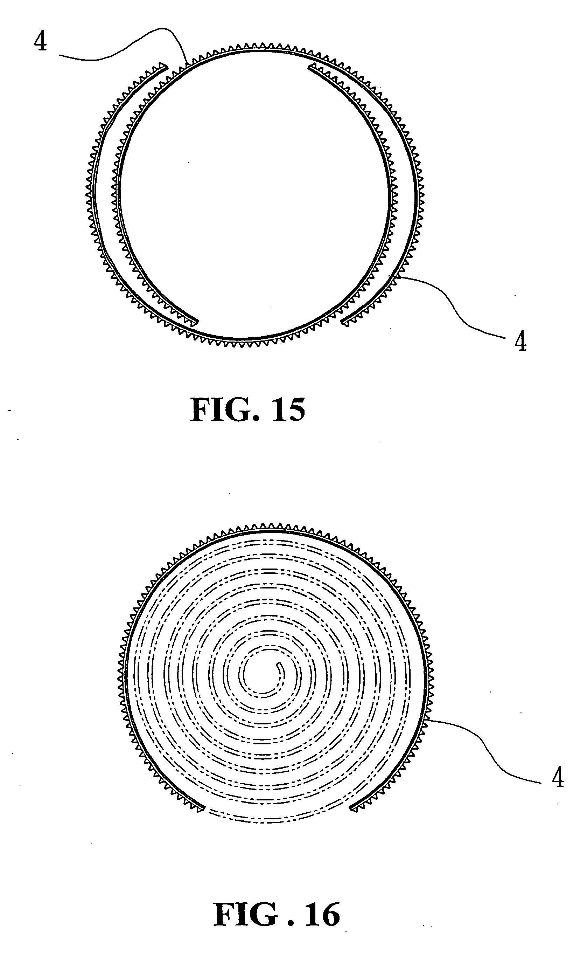

Referring to Figures 15 and 16, the flexible foil 4 that is manufactured in the way described above can be deflected in the form of a cylinder with an axially-extending slit so that a plurality of flexible foils 4 in the form of cylinder can be fit over each other as shown in Figure 15. Alternatively, as shown in Figure 16, a length of the flexible foil 4 can be rolled up as a roll. Both facilitate storage and transportation of the flexible foil 4.

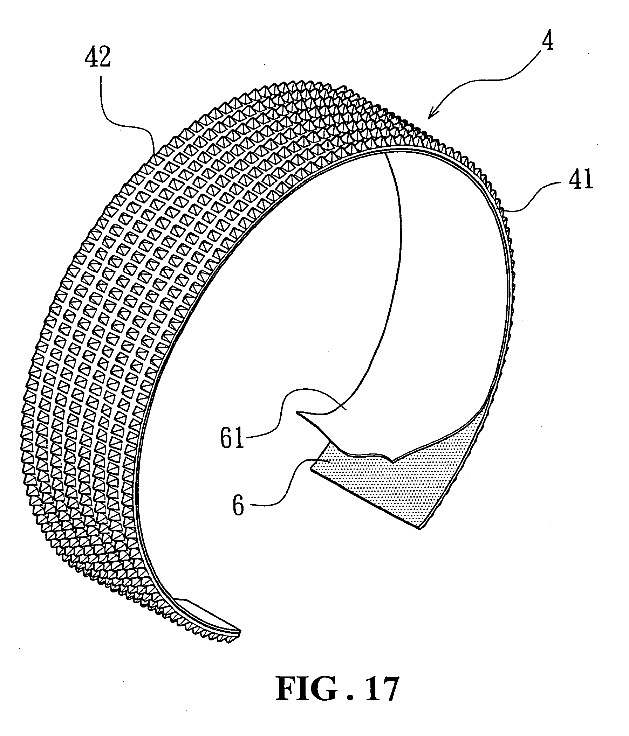

Figure 17 shows a modification of the flexible foil 4 of the present invention, wherein an adhesive layer 6 is coated on the smooth surface 41 of the flexible foil 4 that is opposite to the surface that forms the projections 42. A protective release film 61 is attached to the adhesive layer 6 and the release film 61 can be peeled off to expose the adhesive layer 6 for attaching to an object.

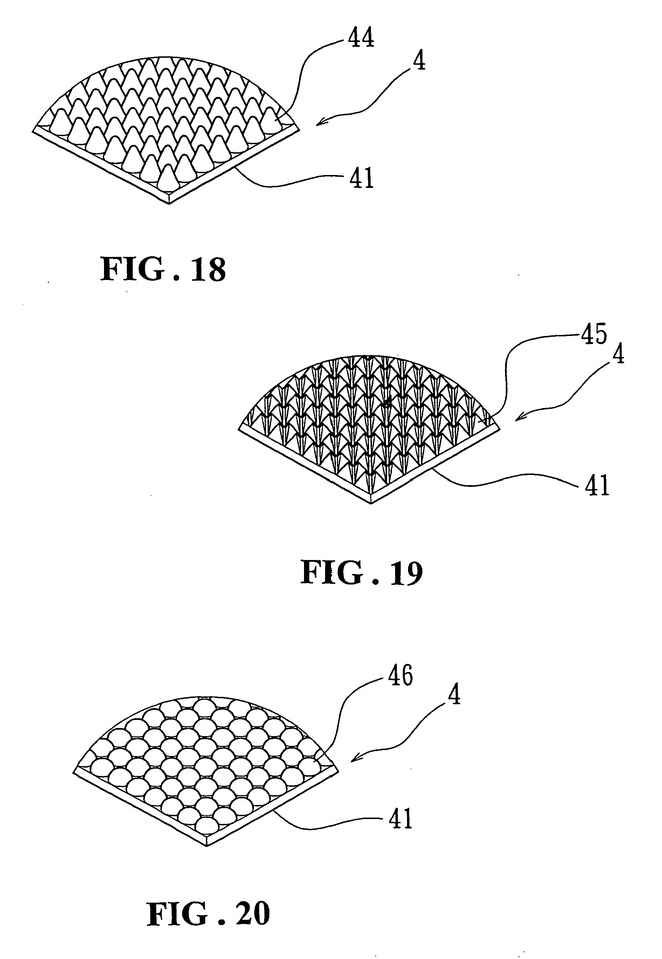

Figures 18-20 show different structures of the projections 42 formed on the surface of the flexible foil 4. The projections 42 can be of any suitable shapes or structures and examples include a cone 44 (Figure 18), a pyramid 45 (Figure 19), or a triangular or quadrilateral cone, and a hemisphere or dome 46 (Figure 20)

Apparently, the present invention provides a thin flexible foil 4, which comprises a surface forming three-dimensional raised projections 42 that effectively reflect and diffract electromagnetic waves. The small thickness of the thin foil 4 allows for saving of material so that the present invention features both excellent isolation of electromagnetic waves and conservation of resources.

Although the present invention has been described with reference to the preferred embodiments thereof, it is apparent to those skilled in the art that a variety of modifications and changes may be made without departing from the scope of the present invention which is intended to be defined by the appended claims.

It will be understood that each of the elements described above, or two or more together may also find a useful application in other types of methods differing from the type described above.

While certain novel features of this invention have been shown and described and are pointed out in the annexed claim, it is not intended to be limited to the details above, since it will be understood that various omissions, modifications, substitutions and changes in the forms and details of the device illustrated and in its operation can be made by those skilled in the art without departing in any way from the spirit of the present invention.

## Claims

1. A flexible foil comprising a foil adapted to enclose an electronic device that generates electromagnetic waves and comprising a flexible sheet having a smooth surface and an opposite surface on which a plurality of three-dimensional raised projections that are lined consecutively.

2. The flexible foil as claimed in Claim 1, wherein a recessed thinned layer is formed between adjacent ones of the projections.

3. The flexible foil as claimed in Claim 2, wherein the recessed thinned layer is constructed so that a thickness between the smooth surface and the thinned layer is between 0.02 to 0.4mm, and wherein the projections are formed to have a height of 0.05 to 1.5mm.

4. The flexible foil as claimed in Claim 1, wherein the flexible foil is deflectable as a cylinder.

5. The flexible foil as claimed in Claim 1 further comprising an adhesive layer applied to the smooth surface.

6. The flexible foil as claimed in Claim 5, further comprising a release film attached to the adhesive layer.

7. The flexible foil as claimed in Claim 1, wherein the foil is coated with an adhesive layer, a release film being attached to the adhesive layer, and wherein the foil, the adhesive layer, and the release film are windable as a roll.

8. The flexible foil as claimed in Claim 1, wherein the projections are of quadrilateral conic shape.

9. The flexible foil as claimed in Claim 1, wherein the projections are of conic shape.

10. The flexible foil as claimed in Claim 1, wherein the projections are of triangular conic shape.

11. The flexible foil as claimed in Claim 1, wherein the projections are of hemispherical shape.

12. A flexible foil comprising a foil adapted to combine with an electromagnetic-wave-generating electronic device of a computer for enclosing the electronic device, the flexible foil comprising a smooth surface and an opposite surface on which a plurality of three-dimensional raised projections that are lined consecutively

13. A flexible foil comprising a foil adapted to combine with an electromagnetic-wave-generating electronic device of a controller and man-machine interface of a machine for enclosing the electronic device, the flexible foil comprising a smooth surface and an opposite surface on which a plurality of three-dimensional raised projections that are lined consecutively.

14. A method for manufacturing a flexible foil, comprising the following steps:
(1) providing a sheet-to-be-processed ;
(2) providing a rolling device for continuously rolling the sheet-to-be-processed, the rolling device comprising first and second rollers, the first roller having a circumference on which rolling teeth are formed, the rollers being arranged to be opposite to and engaging each other between which the sheet-to-be-processed is fed and driven forward while the rolling teeth of the first roller form consecutive projections on the sheet-to-be-processed;
(3) releasing strain induced in the sheet-to-be-processed on which the projections are formed;
(4) performing surface treatment on the sheet-to-be-processed which has been subject to release of strain; and
(5) cutting the sheet-to-be-processed on which the projections are formed into desired sizes to provide the flexible foils.

15. The method as claimed in Claim 14 further comprising, after step (4), a step of polishing a surface of the sheet-to-be-processed that is opposite to a surface forming the projections, so as to provide a smooth surface that is opposite to the projections.

16. The method as claimed in Claim 14 further comprising, after step (5), a step of winding the flexible foil into a cylinder.

17. The method as claimed in Claim 14, wherein the rolling teeth of the first roller are of a polygonal conic shape.

18. The method as claimed in Claim 14, wherein a surface of the sheet-to-be-processed, which is opposite to a surface forming the projections, is coated with an adhesive layer.

19. The method as claimed in Claim 18, wherein a release film is attached to the adhesive layer.

20. The method as claimed in Claim 18, wherein the flexible foil is adapted to enclose an electronic device that generates electromagnetic waves with the projections facing the electronic device.

21. The method as claimed in Claim 18, wherein a surface of the flexible foil, which is opposite to a surface forming the projections, is adapted to attach to an object from which heat is to be dissipated.
